(19) Europäisches Patentamt
European Patent Office
Office européen des brevets

(11) EP 0 862 271 A2

(12) EUROPÄISCHE PATENTANMELDUNG

(43) Veröffentlichungstag:
02.09.1998 Patentblatt 1998/36

(51) Int. Cl.⁶: H03K 5/24

(21) Anmeldenummer: 98102556.2

(22) Anmeldetag: 13.02.1998

(84) Benannte Vertragsstaaten:
AT BE CH DE DK ES FI FR GB GR IE IT LI LU MC NL PT SE
Benannte Erstreckungsstaaten:
AL LT LV MK RO SI

(30) Priorität: 28.02.1997 DE 19708203

(71) Anmelder:
SIEMENS AKTIENGESELLSCHAFT
80333 München (DE)

(72) Erfinder: Wachter, Franz, Dr.
9504 Villach (AT)

(54) Komparatorschaltung

(57) Die Erfindung betrifft eine Komparatorschaltung, die vorteilhafterweise als Ansteuerschaltung bzw. Sensekomparator für einen nachgeschalteten Sägezahngenerator verwendet wird. Die Sensekomparatorschaltung weist einen antiparallel zum ersten Differenzverstärker geschalteten zweiten Differenzverstärker auf, eine Strommeßeinrichtung und Mittel zur Biasstromeinprägung. Im Normalbetrieb, das heißt während der Anstiegsflanke bzw. Abklingflanke eines Sägezahnsignals, wird die Komparatorschaltung lediglich von einem verhältnismäßig kleinen Stand-by-Strom versorgt. Nahe dem Umschaltpunkt des Sägezahnsignales wird dem kleinen Stand-by-Strom ein sehr viel größerer Biasstrom zugeschaltet. Da die Biasstromquelle nur im Umschaltpunkt des Sägezahnsignales einen Stromimpuls liefert, während der Taktflanken des Sägenzahnsignals aber ausgeschaltet bleibt, läßt sich auf diese Weise der Stromverbrauch der Komparatorschaltung drastisch minimieren. Auf diese Weise lassen sich vorteilhafterweise Komparatorschaltungen in SMT-Technologie, das heißt mit der geforderten Hochohmigkeit der Eingangstransistoren, realisieren.

FIG 3

## Beschreibung

Die Erfindung betrifft eine Komparatorschaltung mit einem Differenzverstärker.

In analogen integrierten Schaltungen werden häufig Komparatoren verwendet, um zwei Spannungen miteinander zu vergleichen. Das Ergebnis dieses Vergleichs wird am Ausgang des Komparators durch einen bestimmten Schaltzustand angezeigt. Ein Komparator enthält üblicherweise einen Differenzverstärker, der ausgangsseitig einen nachgeschalteten Transistor ansteuert. Abhängig vom Eingangssignal schaltet der Ausgang der Differenzverstärkerstufe den nachgeschalteten Transistor entweder ein oder aus. Gattungsgemäße Komparatorschaltungen sind beispielsweise aus der EP 0 442 001 B1, insbesondere Figur 1, sowie aus der US 4,529,891, insbesondere Figur 1, bekannt.

Komparatorschaltungen werden üblicherweise in integrierten Sägezahngeneratoren verwendet. Dazu wird eine gängige Schaltung gewählt, die über einen umschaltbaren Konstantstrom einen externen Kondensator auf- bzw. entlädt. Wenn die Kondensatorspannung eine intern generierte Maximalreferenzspannung bzw. Minimalreferenzspannung über- bzw. unterschreitet, schaltet ein Komparator auf einen Entlade- bzw. Ladestrom um, wodurch der externe Kondensator entladen bzw. aufgeladen wird. Typischerweise weist ein integrierter Sägezahngenerator eine Taktfrequenz von 100 KHz bei einem Frequenzfehler von $\pm$ 5 % und einem typischen Tastverhältnis von $t_r/T = 86\%$ auf. Das besondere Problem einer solchen integrierten Schaltung stellt die Forderung des sehr kleinen Frequenzfehlers von $\pm$ 5 % bei einer angenommenen idealen externen Kapazität dar. Die Genauigkeit des Sägezahngenerators wird hierbei im wesentlichen durch die Spannungs- und Stromquellen sowie durch die Eigenschaften des Komparators bestimmt. Die Offsetspannung des Komparators ist bei genügend großer Gleichtaktunterdrückung in beiden Schaltschwellen gleich groß und ein auftretender Frequenzfehler wird kompensiert. Eine Abweichung in der Taktlaufzeit geht jedoch voll in den resultierenden Frequenzfehler ein. Auf diese Weise verkleinert ein „Überschießen" der idealen Schaltschwellen die Taktfrequenz. Je größer das Tastverhältnis wird, desto stärker wirkt sich dieses Verhalten des Komparators in eine Frequenzänderung aus.

Hohe Schaltgeschwindigkeiten können generell mit bipolar realisierten Differenzverstärkern erreicht werden. In der Smart Power-Technologie (SMT) sind jedoch nur sehr langsame Bipolartransistoren verfügbar, die überdies eine schlechte Stromverstärkung aufweisen. In der Smart Power-Technologie müssen aber die Eingangsstrukturen möglichst verlustfrei, d. h. hochohmig, angesteuert werden. Eventuell dem Differenzverstärker vorgeschaltete MOS-Pegelwandler erweisen sich als nachteilig, da sie durch zusätzliche parasitäre Kapazitäten die Schaltzeiten zusätzlich verlängern und den Stromverbrauch aufgrund des großen notwendigen Biasstromes erhöhen. Um der geforderten Hochohmigkeit an den Eingängen nachzukommen, werden als Eingangstransiostoren des Differenzverstärkers feldeffektgesteuerten Bauelementen, wie MOSFETs, IGBTs, etc. verwendet.

Eine Realisierung der bekannten bipolaren Komparatorschaltung aus EP 0 442 001 B1, Figur 1, in MOS-Technologie ist in Figur 1 der Zeichnung dargestellt.

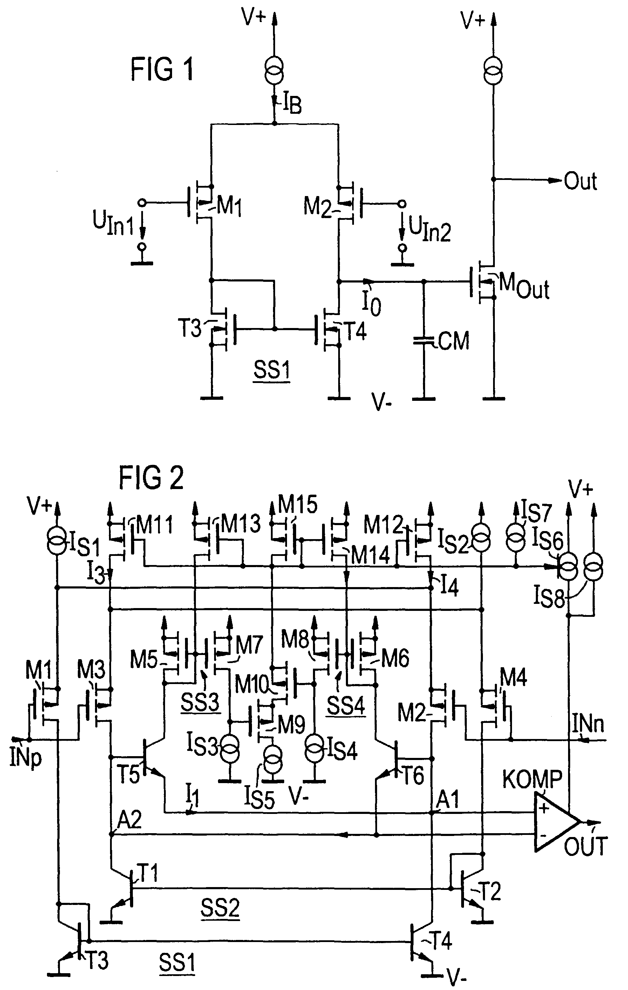

Die Grundzelle des Komparators besteht gemäß Figur 1 der Zeichnung im wesentlichen aus einem Differenzverstärker der ausgangsseitig einen Transistor ansteuert. Der Differenzverstärker besteht aus zwei sourceseitig gekoppelten p-Kanal-Eingangstransistoren M1, M2. Die Eingangstransistoren M1, M2 sind als MOSFETS realisiert. An deren Gateanschlüssen liegen jeweils Eingangssignale UIn1, UIn2 als gegenüber einem negativen Referenzpotential V- auftretende Spannungen an.

Weiterhin besteht der Differenzverstärker aus einem Stromspiegel, dessen Fußpunkt ebenfalls mit dem negativen Pol V-der Versorgungsspannungsquelle und dessen Eingang bzw. Ausgang mit den Drainanschlüssen der beiden MOSFET M1, M2 verbunden ist. Der Stromspiegel ist hier durch die n-Kanal-MOSFET T3, T4 realisiert. Eine Stromquelle IS1 ist zwischen dem positiven Pol V+ der Versorgungsspannungsquelle und den gekoppelten Sourceanschlüssen der MOSFET M1, M2 vorgesehen.

Ausgangsseitig steuert der Differenzverstärker den Gateanschluß eines p-Kanal-MOSFET $M_{OUT}$ an. Die Drain-Source-Laststrecke des MOSFET $M_{OUT}$ ist zwischen dem negativen Pol V- und dem positiven Pol V+ der Versorgungsspannungsquelle geschaltet. Zwischen dem Drainanschluß des MOSFET $M_{OUT}$ und dem positiven Pol V+ der Versorgungsspannungsquelle ist eine zweite Stromquelle Q geschaltet. Des weiteren wird am Drainanschluß des MOSFET $M_{OUT}$ das Ausgangssignal OUT der Komparatorschaltung ausgekoppelt.

Unter Vernachlässigung anderer parasitärer Kapazitäten wurde in der MOS-Komparatorschaltung nur die dominante Millerkapazität $C_M$ der Ausgangsstufe dargestellt. Die Millerkapazität $C_M$ ist der Gate-Source-Strecke des MOSFET $M_{OUT}$ parallel geschaltet.

Der Ladestrom der Millerkapazität $C_M$ ergibt sich dann zu

$$I_0 = \beta U_D \sqrt{\frac{I_B}{\beta} - \frac{U_D^2}{4}} \qquad (1).$$

Hierbei ist $\beta$ der Stromverstärkungsfaktor, $I_B$ ist der Biasstrom, $U_D$ = UIn1-UIn2 ist die Differenz der Eingangsspannungen. Im linearen Arbeitsbereich ergibt sich dann die Gate-Source-Spannungsänderung pro Zeiteinheit zu

$$\frac{dU_{GS}}{dt} = \frac{\beta \, U_D}{C_M} \sqrt{\frac{I_B}{\beta} - \frac{U_D^2}{4}} \qquad (2).$$

Aus Gleichung (2) ist entnehmbar, daß für kleine Verzögerungszeiten des Komparators bzw. für eine große Gate-Source-Spannungsänderung pro Zeiteinheit am MOSFET $M_{OUT}$ bei gegebener Millerkapazität $C_M$ und kleinen Differenzspannungen $U_D$ am Eingang (flache Anstiegsrampe des Sägezahnsignals) ein großer Stromverstärkungsfaktor $\beta$ bei einem gleichzeitig hohen Biasstrom $I_B$ erforderlich ist.

Gleichzeitig ist $\beta \sim$ W/L direkt proportional zum Verhältnis von Kanalweite zu Kanallänge und ist damit proportional zu den bisher vernachlässigten parasitären Kapazitäten der Eingangstransistoren der Differenzverstärkerstufe. Dadurch ist eine Vergrößerung der Verstärkungsfaktoren der MOSFET M1, M2 nur bedingt sinnvoll. Um die Verzögerungszeiten zu verkleinern, muß man folglich auf eine Stromerhöhung zurückgreifen, wobei die Gate-Source-Spannungsänderung pro Zeiteinheit als Ausgangsgröße gemäß Gleichung (2) nur etwa proportional zur Quadratwurzel des Biasstromes $I_B$ ansteigt.

Aufgabe der vorliegenden Erfindung ist es daher, eine Komparatorschaltung der eingangs genannten Art derart bereitzustellen, bei der der Stromverbrauch erheblich reduziert wird und die auch bei Verwendung von Eingangstransistoren in SMT-Technologie hohe Schaltgeschwindigkeiten selbst bei flachen zeitlichen Spannungsflanken zuläßt.

Erfindungsgemäß wird diese Aufgabe durch eine Komparatorschaltung der eingangs genannten Art, die gekennzeichnet ist durch

- mindestens einen weiteren Differenzverstärker,
- eine Strommeßeinrichtung, die die jweiligen Ausgänge der Differenzverstärker koppelt und die Eingangssignale miteinander vergleicht,
- eine erste Verstärkerstufe, die bei gleichen Eingangssignalen aktiviert wird und eine steuerbare Bias-Stromquelle einschaltet.

Die Komparatorschaltung entsprechend Patentanspruch 1 wird vorteilhafterweise als Ansteuerschaltung für einen nachgeschalteten Sägezahngenerator verwendet. Diese Komparatorschaltung weist des Vorteil auf, daß im Normalbetrieb, das heißt während der Anstiegsflanke bzw. Abklingflanke des Sägezahnsignals, die Komparatorschaltung ausgangsseitig einen verhältnismäßig kleinen Stand-by-Strom bereitstellt.

Nahe dem Umschaltpunkt des Sägezahnsignales wird dem kleinen Stand-by-Strom ein sehr viel größerer Biasstrom zugeschaltet. Dieses Zuschalten eines Biasstromes erfolgt nach einem Vergleichen der Eingangssignale welche sich aus dem Sägezahnsignal und einem Referenzpotential ergeben, durch eine Strommeßeinrichtung. Nahe dem Schaltpunkt sind üblicherweise die Eingangssignale gleich. Dies wird durch die Strommeßeinrichtung erkannt. Eine Biasstromquelle wird zugeschaltet.

Da diese Biasstromquelle nur im Umschaltpunkt des Sägezahnsignales einen Stromimpuls liefert, während der Taktflanken des Sägenzahnsignals aber ausgeschaltet bleibt, läßt sich auf diese Weise der Stromverbrauch der Komparatorschaltung erheblich minimieren.

Vorteilhafterweise ist die Komparatorschaltung einem weiterem Komparator vorgeschaltet. Die vorgeschaltete Komparatorschaltung dient dann als Sensekomparator für den nachgeschalteten Komparator. Der nachgeschaltete Komparator kann typischerweise der Komparator eines Sägezahngenerators bzw. Oszillators sein.

Vorteilhaft erweist sich, wenn die Verstärkung des Sensekomparators mitgenutzt werden kann. Eine solche Anordnung wird dann als zweistufige Komparatorschaltung bezeichnet.

Vorteilhafterweise sind die Eingangstransistoren der Differenzverstärker feldeffektgesteuert. Dadurch kann der Forderung der Hochohmigkeit, die sich aus der SMT-Technologie ergibt, erfüllt werden.

Typischerweise ist die steuerbare Stromquelle zur Biasstromeinprägung ein Halbleiterbauelement. Ein solches Bauelement kann beispielsweise ein Leistungs-MOSFET sein, das über sein Gate gesteuert wird und über dessen Drain-Source-Laststrecke dem nachgeschalteten Komparator der Biasstrom zugeführt wird. Für eine große Stromverstärkung wird üblicherweise ein sehr großes W/L-Verhältnis gewählt.

Die Mittel zur Stromeinprägung der Differenzverstärker sind typischerweise als Stromquellen realisiert.

Die Erfindung wird nachfolgend anhand der in den Figuren der Zeichnung dargestellten Ausführungsbeispiele näher erläutert. Es zeigt:

Figur 1    eine bekannte MOS-Komparatorschaltung;

Figur 2    eine allgemeine Ausführungsform des Prinzips der erfindungsgemäßen MOS-Komparatorschaltung;

Figur 3    eine bevorzugte Ausführungsform des Prinzips der erfindungsgemäßen MOS-Komparatorschaltung.

Figur 2 zeigt eine Komparatorschaltung, bestehend aus zwei Differenzverstärkern, die zueinander invertiert parallel geschaltet sind. Der erste Differenzverstärker besteht aus den Eingangstransistoren M1, M2 und den Transistoren T3, T4, die in Stromspiegelschaltung SS1 zueinander geschaltet sind. Entsprechend besteht der zweite Differenzverstärker aus den Eingangstransistoren M3, M4 und den Stromspiegeltransistoren T1, T2 des Stromspiegels SS2.

Die beiden Differenzverstärker sind zwischen einem positiven Pol V+ und einem negativen Pol V- der Versorgungsspannungsquelle geschaltet. An jeweils dem ersten Eingang der Differenzverstärker liegt ein erstes Eingangssignal INp an den Gateanschlüssen der Transistoren M1 und M3 an.

An den jeweils zweiten Eingängen der Differenzverstärker liegt das zweite Eingangssignal INn an den Gateanschlüssen der Transistoren M2 und M4 an. Zwischen den gekoppelten Sourceanschlüssen der Transistoren M1, M2 bzw. M3, M4 und dem positiven Pol V+ der Versorgungsspannungsquelle sind Mittel zur Stromeinprägung IS1 bzw. IS2 geschaltet.

Die Mittel zur Stromeinprägung IS1, IS2 können durch Stromquellen realisiert sein. Die Stromquellen IS1, IS2 liefern einen verhältnismäßig geringen Strom, der beispielsweise einem Stand-by-Strom entspricht.

Um der Forderung der Hochohmigkeit bei Komparator-Schaltungen in SMT-Technologie nachzukommen, sind im vorliegenden Beispiel die Eingangstransistoren M1 bis M4 feldeffektgesteuert. Es handelt sich hierbei um p-Kanal-MOSFETS. Die Transistoren M1 bis M4 können aber auch bipolar realisiert werden. Es sollten dann aber Mittel zur hochohmigen Ansteuerung der Eingangstransistoren, beispielsweise durch einen MOS-Pegelwandler oder ähnlichem, getroffen werden.

Die Stromspiegeltransistoren T1 bis T4 sind im vorliegenden Beispiel bipolar realisiert worden. Es ist allerdings auch denkbar, die Transistoren T1 bis T4 entsprechend Figur 1 durch feldeffektgesteuerte Transistoren zu ersetzen.

Eine weitere Möglichkeit bei Realisierung der Stromspiegelschaltungen ergibt sich, indem in die Laststrecke der Eingangstransistoren Widerstände geschaltet werden. Ausgangsseitig steuert die Komparatorschaltung über die Ausgänge A1 und A2 den positiven bzw. negativen Eingang eines nachgeschalteten weiteren Komparators KOMP an.

Dabei ist der Ausgang A1 mit dem Ausgang des ersten Differenzverstärkers und der Ausgang A2 mit dem Ausgang des zweiten Differenzverstärkers verbunden. Zwischen die Ausgänge A1 und A2 der beiden Differenzverstärker ist jeweils ein Schalttransistor T5 bzw. T6 geschaltet. Die Schalttransistoren T5 und T6 sind im vorliegenden Beispiel durch Bipolartransistoren realisiert, sie können aber auch durch feldeffektgesteuerte Halbleiterbauelemente realisiert werden.

Die Basis-Emitterstrecke des Transistors T5 verbindet den Ausgang des zweiten Differenzverstärkers mit dem Ausgang des ersten Differenzverstärkers und die Basisemitterstrecke des Transistors T6 verbindet den Ausgang des ersten Differenzverstärkers mit dem Ausgang des zweiten Differenzverstärkers.

Die Transistoren T5 und T6 sind kollektorseitig mit dem Eingang jeweils eines dritten und vierten Stromspiegels SS3, SS4 verbunden. Der dritte Stromspiegel SS3 enthält die Transistoren M5 und M7, der vierte Stromspiegel SS4 enthält die Transistoren M6 und M8. Die Transistoren M5 bis M8 sind im vorliegenden Beispiel p-Kanal-MOSFET.

Sourceseitig sind die Transistoren M5 bis M8 mit dem positiven Pol V+ der Versorgungsspannungsquelle verbunden. An dem Ausgang des dritten und vierten Stromspiegels SS3, SS4 sind zwischen dem Drainanschluß des Transistors M7 bzw. M8 und dem negativen Pol V- der Versorgungsspannungsquelle Referenzstromquellen IS3 bzw. IS4 geschaltet.

Zusätzlich sind die Ausgänge des dritten und vierten Stromspiegels SS3, SS4 über eine UND-Verknüpfung miteinander gekoppelt. Die UND-Verknüpfung besteht aus zwei p-Kanal-MOSFETS M9, M10, deren Gate-Anschlüsse von den Ausgängen der Stromspiegel SS3 bzw. SS4 angesteuert werden und deren Drain-Source-Laststrecken in Reihe geschaltet sind. Die UND-Verknüpfung ist zwischen dem positiven Pol V+ und dem negativen Pol V- der Versorgungsspannungquelle angeordnet.

Der Transistor T5, der Stromspiegel SS3 sowie die Referenzstromquelle IS3 bilden eine erste Strommeßeinrichtung für den ersten Differnzverstärker. Entsprechend bilden der Transistor T6, der Stromspiegel SS4 und die Referenzstromquelle IS4 eine zweite Strommeßeinrichtung für den zweiten Differenzverstärker.

Zwischen der UND-Schaltung M9, M10 und dem negativen Pol V-der Versorgungsspannungsquelle sind weitere Mittel zur Stromeinprägung IS5 geschaltet. Zwischen der UND-Schaltung M9, M10 und dem postiven Pol V+ der Versorgungsspannungsquelle ist die Dran-Source-Laststrecke eines Spiegeltransistors M15 geschaltet.

Zwischen dem ersten Differenzverstärker bzw. zweiten Differenzverstärker und dem positiven Pol V+ der Versorgungsspannungquelle ist jeweils die Drain-Source-Laststrecke der Transistoren M12 bzw. M11 geschaltet. Gateseitig werden die Transistoren M11, M12 und M15 von der Stromquelle IS7 angesteuert, die an ihrem anderen Ende mit dem positiven Pol V+ der Versorgungsspannungquelle verbunden ist. Die Transistoren M11 und M15 bzw. M12 und M15 sind in Stromspiegelschaltung miteinander verschaltet.

Die weiteren Mittel zur Stromeinprägung IS5 können beispielsweise durch eine Stromquelle realisiert sein. Die Stromquelle IS5 ist im vorliegenden Beispiel sehr viel größer dimensioniert als die Stand-by-Stromquellen IS1 und IS2. Die Stromquelle IS5 und die in Stromspiegelschaltung geschalteten Transistoren M11, M12, M15 dienen der Biasstromeinprägung für den ersten und zweiten Differnzverstärker, wobei der Biasstrom über die UND-Schaltung M9, M10 zugeschaltet bzw. abgeschaltet werden kann.

Zwischen dem Fußpunkt des dritten Stromspiegels SS3 und des vierten Stromspiegels SS4 und dem positiven Pol V+ der Versorgungsspannungquelle sind jeweils die Drain-Source-Laststrecken der Transistoren M13 bzw. M14 geschaltet. Gateseitig werden die Transistoren M13 und M14 ebenfalls durch die Stromquelle IS7 angesteuert und sind somit ebenfalls in Stromspiegelschaltung mit dem Transistor M15 verschaltet.

Die Transistoren M5 bis M15 sind im vorliegenden Beispiel durch p-Kanal-MOSFETS realisiert, können aber auch bipolar ausgeführt sein.

Der Ausgang der UND-Schaltung M9, M10 steuert zusätzlich eine steuerbare Stromquelle IS6 an. Diese steuerbare Stromquelle IS6 ist an einer Seite mit dem positiven Pol V+ der Versorgungsspannungquelle verbunden und an ihrem Ausgang steuert sie den weiteren Komparator KOMP an. Die steuerbare Stromquelle IS6 liefert einen Biasstrom für den weiteren Komparator KOMP. Die steuerbare Biasstromquelle IS6 wird vorteilhafterweise durch einen MOSFET mit sehr großem W/L-Verhältnis realisiert.

Parallel zur steuerbaren Biasstromquelle IS6 ist eine weitere Stromquelle IS8 geschaltet. Dabei ist die Stromquelle IS8 sehr viel niedriger dimensioniert, als die steuerbare Stromquelle IS6. Üblicherweise liefert die Stromquelle IS8 einen Stand-by-Strom in der Größenordnung von etwa 50 $\mu$A und die steuerbare Biasstromquelle einen Strom von etwa 1 mA.

Der positive Pol V+ der Versorgungsspannungquelle liegt üblicherweise auf dem Potential 7 V, der negative Pol V- der Versorgungsspannungquelle liegt üblicherweise auf dem Potential der Bezugsmasse.

Die Komparatorschaltung entsprechend Figur 2 der Zeichnung, welche zwei antiparallel verschaltete Differenzverstärker sowie zwischen den Differenzverstärkern angeordnete Mittel zur Strommessung und Mittel zur Zuschaltung eines Biasstromes enthält, kann beispielsweise als Sensekomparator verwendet werden. Dieser Sensekomparator ist dem eigentlichen Komparator KOMP vorgeschaltet. Der nachgeschaltete Komparator ist in seinem Normalzustand durch den Sensekomparator ausgeschaltet.

Der Sensekomparator mißt üblicherweise die Sägezahnspannung. Nahe des Schaltungpunktes des Sägezahnsignals erzeugt der Sensekomparator einen Biasstromimpuls, der sehr viel größer ist als der Standby-Strom. Dieser Biasstrom wird dem eigentlichen, nachgeschalteten Komparator zugeführt. Dieser Komparator ist beispielsweise der Komparator eines Oszillators für einen Sägezahngenerator.

In Figur 2 ist eine zweistufige Komparatorschaltung gezeigt. Bei dieser zweistufigen Komparatorschaltung kann die Verstärkung des dem eigentlichen Komparators vorgeschalteten Sense-Komparators mitgenutzt werden.

Nachfolgend wird die genaue Funktionsweise der zweistufigen Komparatorschaltung entsprechend Figur 2 näher erläutert.

Weit außerhalb des Schaltpunktes, z.B. bei einer Dreieckspannung, wird der eigentliche Komparator KOMP entsprechend Figur 2 lediglich von sehr kleinen „Stand-by-Strömen" der Stromquelle IS8 versorgt. Die Stromquelle IS7 liefert einen verhältnismäßig schwachen Strom. Dadurch sind die Transistoren M11 bis M15, die gateseitig mit der Stromquelle IS7 verbunden ist, ausgeschaltet. Somit ist auch die Bias-Stromquelle IS6 ausgeschaltet.

Ist das Potential des ersten Eingangssignals INp sehr viel niedriger als das Potential des zweiten Eingangssignals INn, so sind die Transistoren M1 und M3 geöffnet, M2 und M4 sind gesperrt. Da das Drainpotential des Transistors M3 hoch ist, leitet der Bipolartransistor T5. Sein Emitterstrom I1 fließt in den Kollektor von T4 ab. Dieser Strom nimmt den Wert des Stromes von IS1 an, da dieser von T3 nach T4 gespiegelt wird. Kollektorseitig vom Transistor T5 wird der Strom von IS1 über den Stromspiegel SS3 mit dem Strom der Stromquelle IS3 verglichen. Da die Stromquelle IS3 und der Stromspiegel M5, M7 so dimensioniert sind, daß für diesen Zustand gilt: IS1 = I2 > IS3 = IS1:2 , ist der Transistor M9 der UND-Schaltung ausgeschaltet.

Der Strom über dem Transistor T6 hingegen ist 0, da sein Emitterpotential größer als sein Basispotential ist. Folglich fällt das Gatepotential des Transistors M10, wodurch dieser Transistor eingeschaltet wird. Die UND-Verknüpfung der Transistoren M9 und M10 kann die Stromquelle IS5 dennoch nicht durchschalten, da der Transistor M9 der UND-Schaltung noch ausgeschaltet ist. Dadurch macht die Stromquelle IS7 die Strombank bestehend aus den Transistoren M11 und M12 unwirksam sowie die Stromquelle IS6. Die für eine Schaltungshysterese zuständigen Transistoren M12 und M13 sind ebenfalls ausgeschaltet.

Nähern sich die Potentiale der Eingängssignale INp, INn einander an, übernimmt der Transistor M2 immer mehr Stromanteile von der Stromquelle IS1. Der vom Transistor T3 zum Transistor T4 gespiegelte Strom nimmt ab, wodurch auch der Emitterstrom I1 des Transistors T5 kleiner wird. Sobald der Strom I1 gleich dem Strom I2, bzw. I1 = I2 $\leq$ IS3 = IS/2 ist, wird auch der Transistor M9 geöffnet. Der Transistor M10 ist bereits offen. Der Drainstrom des Transistors M15 wird nun durch die Stromquelle IS5 bzw. IS7 bestimmt und wird über die Transistoren M11 und M12 sowie über die steuerbare Stromquelle vervielfacht. Die erhöhten Biasströme I3 und I4 der Transistoren M11 und M12 tragen in der konkreten Dimensionierung etwa das 10fache der Grundströme. Diese Biasströme I3 und I4 werden über die Ausgänge A1 und A2 der Komparatorschaltung dem positiven bzw. negativen Eingang des nachgeschalteten Komparators KOMP zugeleitet.

Eine unangenehme Nebenerscheinung wird durch die Transistoren M13 und M14 verhindert. Wird beispielsweise der Biasstrom I4 durch das Öffnen des Transistors M9 aufgeschaltet, steigt auch der Wert des Stromes I1 sprunghaft an, da der Transistor T4 über den Transistor T3 des Stromspiegels SS1 einen höheren Strom ziehen kann. Ohne dem Transistor M13 würde der Strom I2 wieder ansteigen und der Transistor M9 unerwünscht ausschalten. Um dieses „Einschwingen" zu verhindern, kann das sprunghafte Ansteigen des Stromes I2 durch den Transistor M13 verhindert werden. Wird der Drainstrom von M13 größer als der Sprung des Stromes I1 gewählt, erfährt die Umschaltung eine Stabilisierung durch eine Hysterese.

Im Schaltpunkt, wenn die Potentiale der Eingangssignale INp und INn der Differenzverstärkerstufen gleich sind, wird die eigentliche Komparatorschaltung KOMP nun durch einen wesentlich erhöhten Biasstrom versorgt. Sowohl der Transistor T5 als auch der Transistor T6 sperren. Der Komparator wird dabei in seiner Funktion nicht beeinträchtigt.

Nach dem Schaltpunkt, wenn das Potential des ersten Eingangssignals INp größer ist als das Potential des zweiten Eingangssignals INn, ist der Transistor T5 geschlossen. Der Transistor T6 öffnet, sobald seine Basisemitter-Schwellspannung erreicht ist. Da das Spiegelverhältnis des Stromspiegels SS1 bzw. SS2 jeweils gleich 1 ist, schließt der Transistor M10 genau dann, wenn die Forderung I5-I6 = I7 ≥ IS2/2 erfüllt ist. Die Biasströme I3, I4 sowie die Stromquelle IS6 werden abgeschaltet. Der Komparator KOMP befindet sich nun wieder im Stand-by-Betrieb.

Die Transistoren T5 und T6 haben zusätzlich die Aufgabe die Sättigung der Transistoren T4 und T1 zu verhindern. So folgt das Kollektorpotential des Transistors T1 bei einem weiterem Ansteigen des Kollektorpotentials des Transistors T4 diesem und bildet so eine Basisemitterdiode.

Grundsätzlich wäre es auch möglich, die UND-Verknüpfung aus den Transistoren M9 und M10 durch eine Verbindung der Kollektoren der Transistoren T5 und T6 zu realisieren. Damit könnten die Transistoren M6, M8, M10, M14 und die Stromquelle IS4 eingespart werden.

Die Schaltung entsprechend Figur 2 weist folgenden Vorteil auf. Das Zuschalten des Biasstromes darf nicht zu langsam vor sich gehen, um schon vor Erreichen des Schaltpunktes den vollen Biasstrom zu erreichen. Je nach Steilheit der ansteigenden bzw. abfallenden Sägezahnflanke besteht eine unterschiedliche Anforderung an die Zuschaltgeschwindigkeit, die nur durch eine Vergrößerung des jeweiligen Grundstromes gesteigert werden kann. Steile Flanken benötigen einen höheren Grundstrom, der aber auch nur während einer vom Tastverhältnis abhängigen kürzeren Zeit fließt. Die Stand-by-Ströme der Stromquellen IS1 und IS2 können somit unabhängig voneinander entsprechende Steigung des Eingangssignals gewählt werden, um den Gesamtstromverbrauch zu minimieren.

In Figur 2 ist ein zweistufiger Komparator mit „Stand-by-Schaltung" angegeben, der nur während des Schaltpunktes beispielsweise bei einer Dreiecksspannung, einen Biasstromimpuls zuschaltet. Dadurch kann der Gesamtstromverbrauch der Komparatorschaltung erheblich minimiert werden. Trotzdem werden hohe Schaltgeschwindigkeiten auch bei flachen zeitlichen Spannungsflanken trotz Verwendung von p-Kanal-MOSFETS gewährleistet.

Im Augenblick der Stromaufschaltung werden die Gate-Source-Kapazitäten der Eingangstransistoren M1 bis M4 aufgeladen, wodurch besonders bei großen Verstärkungsfaktoren β ein transienter Stromimpuls an die interne Spannungsvorgabe gelangen kann. Daher ist es unter Umständen notwendig, die Eingangstransistoren M1 bis M4 kapazitiv zu stützen. Ansonsten könnte eine kurzzeitige Änderung der Spannungsvorgabe zu einem frühzeitigen Umschalten des Komparators führen, was unter allen Umständen ausgeschlossen werden muß.

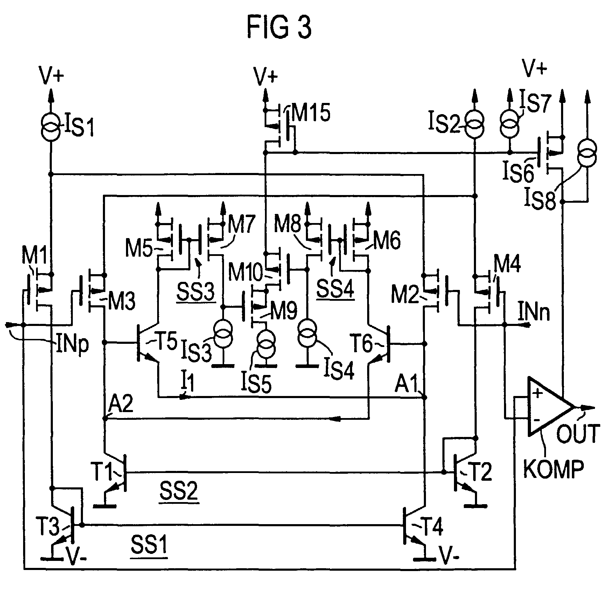

Figur 3 zeigt eine weitere bevorzugte Ausgestaltung der erfindungsgemäßen Komparatorschaltung. Die Komparatorschaltung entsprechend Figur 3 weist im wesentlichen die Elemente der Komparatorschaltung aus Figur 2 auf.

Im Gegensatz zu Figur 2 sind hier bei dem Sensekomparator die beiden Eingänge INp und INn direkt mit dem positiven bzw. negativen Eingang des nachgeschalteten, eigentlichen Komparators KOMP verbunden. Die Ausgänge A1 und A2 sind somit nicht mehr mit dem eigentlichen Komparator KOMP verbunden. Bei der Realisierung der Sense-Komparatorschaltung entsprechend Figur 3 entfallen damit auch die Transistoren M11 - M14 der Stromspiegelschaltung. Somit steuert nur Transistor M15 die steuerbare Stromquelle IS6 an. Die steuerbare Stromquelle IS6 ist in Figur 3 als MOSFET dargestellt worden.

Die Schaltung entsprechend Figur 3 wird als einstufige Komparatorschaltung bezeichnet. Die Verstärkung des Sense-Komparators wird nicht mitgenutzt. Die Schaltung weist allerdings gegenüber der Schaltung aus Figur 2 den Vorteil auf, daß die erwähnten unangenehmen Nebenerscheinungen, i.e. „Einschwingen" der Komparatorschaltung, entfallen.

Bezugszeichenliste

| | |
|---|---|
| M1, M2 | Eingangstransistoren des (ersten) Differenzverstärkers |
| M3, M4 | Eingangstransistoren des zweiten Differenzverstärkers |
| M5, M7 | Transistoren des dritten Stromspiegels |
| M6, M8 | Transistoren des vierte Stromspiegels |
| M9, M10 | Transistoren der UND-Schaltung |
| M11 - M15, IS6 | Stromspiegelschaltungtransistoren |
| M<sub>out</sub> | Transistor im Ausgangskreis einer üblichen Komparatorschaltung |
| T1, T2 | Stromspiegeltransistoren des zweiten Differenzverstärkers |
| T3, T4 | Stromspiegeltransistoren des ersten Differenzverstärkers |
| T5, T6 | Schalttransistoren, Koppeltransistoren zwischen erstem und zweiten Diffferenzverstärker |
| SS1 | Stromspiegel des ersten Differenzverstärkers |
| SS2 | Stromspiegel des zweiten Differenzverstärkers |
| SS3, SS4 | dritter und vierter Stromspiegel |

I1                       Emitterstrom von T5

I3, I4              Biasströme

$I_B$                     Biasstrom

IS1                   (Stand-by-)Stromquelle des (ersten) Differenzverstärkers

IS2                   Stand-by-Stromquelle des zweiten Differenzverstärkers

IS3, IS4          Referenzstromquellen

IS5                   Biasstromquelle

IS6                   steuerbare Biasstromquelle

IS7                   Stromquelle

IS8                   Stand-by-Stromquelle

Q                      Stromquelle

UIn1, UIn2      Eingangsspannungen der Differenzverstärker

V+, V-              erster bzw. zweiter Pol der Versorgungsspannungquelle

INp, INn          Eingangssignale der beiden Differenzverstärker

OUT                 Ausgangssignal der Komparatorschaltung

A1, A2             Ausgänge der Differenzverstärker

KOMP              nachgeschalteter Komparator

$C_M$                Millerkapazität

**Patentansprüche**

1. Komparatorschaltung mit einem Differenzverstärker
**gekennzeichnet durch**

   - mindestens einen weiteren Differenzverstärker,
   - eine Strommeßeinrichtung, die die jweiligen Ausgänge (A1, A2) der Differenzverstärker koppelt und die Eingangssignale (INp, INn) miteinander vergleicht,
   - eine erste Verstärkerstufe (IS5, M15, IS6), die bei gleichen Eingangssignalen (INp, Inn) aktiviert wird und eine steuerbare Bias-Stromquelle (IS6) einschaltet.

2. Komparatorschaltung nach Anspruch 1,
   **dadurch gekennzeichnet**, daß mindestens einer der Differenzverstärker folgende Merkmale aufweist:

   - einen ersten und zweiten Eingangstransistor (M1, M2; M3, M4), an deren Basen jeweils ein erstes und zweites Eingangssignal (INp, INn) angelegt sind und deren Kollektoren mit dem ersten Pol (V-) der Versorgungsspannungsquelle verbunden sind,
   - eine Stromspiegelschaltung (SS1, SS2), die in die Kollektorleitung des ersten und zweiten Eingangstransistor (M1, M2; M3, M4) geschaltet ist,
   - Mittel zur Stromeinprägung (IS1, IS2), die mit den gekoppelten Emittern vom ersten und zweiten Eingangstransistor (M1, M2; M3, M4) und dem zweiten Pol (V+) der Versorgungsspannungsquelle verbunden sind.

3. Komparatorschaltung nach einem der Ansprüche 1 bis 2,
   **dadurch gekennzeichnet,** daß die weiteren Differenzverstärker entsprechend dem ersten Differenzverstärker verschaltet sind und zu diesem invertiert parallel geschaltet sind.

4. Komparatorschaltung nach einem der Ansprüche 1 bis 3,
   **dadurch gekennzeichnet,** daß die Strommeßeinrichtung eine dritte und die vierte Stromspiegelschaltung (SS3, SS4) enthält, die jeweils eingangsseitig über einen ersten bzw. zweiten Schalttransistor (T5; T6) mit dem zweiten bzw. ersten Differenzverstärker gekoppelt sind und ausgangsseitig mit jeweils einer ersten bzw. zweiten Referenzstromquelle (IS3; IS4) verbunden sind, wobei die dritte und die vierte Stromspiegelschaltung (SS33, SS4) ausgangsseitig über eine UND-Schaltung (M9, M10) miteinander gekoppelt sind.

5. Komparatorschaltung nach einem der Ansprüche 1 bis 4,
   **gekennzeichnet durch** einen weiteren Komparator (KOMP), der von der Komparatorschaltung angesteuert wird.

6. Komparatorschaltung nach einem der Ansprüche 1 bis 5,
   **dadurch gekennzeichnet,** daß weitere Mittel zur Stromeinprägung (M11, M12, M15, IS5) vorgesehen sind, wobei die weiteren Mittel zur Stromeinprägung (M11, M12, M15, IS5) die zweite Verstärkerstufe bilden.

7. Komparatorschaltung nach einem der Ansprüche 1 bis 6,
   **dadurch gekennzeichnet,** daß die Eingangstransistoren (M1 - M4) feldeffektgesteuert sind.

8. Komparatorschaltung nach einem der Ansprüche 1 bis 7,
   **dadurch gekennzeichnet,** daß die steuerbare Bias-Stromquelle (IS6) ein steuerbares Halbleiterbauelement ist.

9. Komparatorschaltung nach einem der Ansprüche 1 bis 8,
   **dadurch gekennzeichnet,** daß die ersten und zweiten Mittel zur Stromeinprägung (IS1, IS2) Stromquellen sind.

10. Komparatorschaltung nach einem der Ansprüche 1 bis 9,

**gekennzeichnet durch** einen der Komparatorschaltung und/oder dem weiteren Komparator (KOMP) ausgangsseitig nachgeschalteteten Sägezahngenerator oder Oszillator.

FIG 1

FIG 2

# FIG 3